# EUROPÄISCHE PATENTSCHRIFT

(11) **EP 1 592 070 B1**
(45) Veröffentlichungstag und Bekanntmachung des Hinweises auf die Patenterteilung: **12.09.2018**
(21) Anmeldenummer: 05004952.7
(22) Anmeldetag: 07.03.2005
(51) Int. Cl.: H01L 31/0216, H01L 31/0224, H01L 33/00

(54) **Strahlungsemittierendes und/oder -empfangendes Halbleiterbauelement und Verfahren zur strukturierten Aufbringung eines Kontakts auf einen Halbleiterkörper**
Semiconductor light emitting and/or receiving device and method for structured contact deposition onto a semiconductor chip
Dispositif électroluminescent ou détection de lumière semiconducteur et procédé de deposition structurée d'un contact sur une puce semiconductrice

(30) Priorität: 30.04.2004 DE 102004021420; 04.08.2004 DE 102004037868
(43) Veröffentlichungstag der Anmeldung: 02.11.2005
(73) Patentinhaber: OSRAM Opto Semiconductors GmbH, 93055 Regensburg (DE)
(72) Erfinder: Jonda, Christoph, 93128 Regenstauf (DE); Zehnder, Ulrich, 93049 Regensburg (DE); Strauss, Uwe, 93077 Bad Abbach (DE)
(74) Vertreter: Epping - Hermann - Fischer

(56) Entgegenhaltungen:
- EP-A1- 0 683 528
- WO-A-02/075819
- WO-A-03/038913
- JP-A- 58 142 583
- JP-A- 60 066 880
- JP-A- 2000 036 616
- JP-A- 2003 298 111
- US-A- 4 860 069
- US-A- 5 189 496
- US-A1- 2004 079 994
- US-B1- 6 603 146

## Beschreibung

Die Erfindung betrifft ein Verfahren zur strukturierten Aufbringung eines Kontakts auf einen Halbleiterkörper gemäß dem Oberbegriff des Patentanspruchs 1.
In der DE 101 52 922 A1 ist ein gattungsgemäßes Halbleiterbauelement beschrieben. Gemäß der dortigen Figur 1 ist ein Halbleiterkörper auf einem Substrat angeordnet. Auf dem Halbleiterkörper ist ein Kontakt angeordnet. Weiterhin ist eine Schutzschicht vorgesehen, die sich bis zu der dem Halbleiterkörper gegenüberliegenden Seite des Kontakts erstreckt und auf dieser angeordnet ist.
Die Druckschriften EP 0683528 A1, US 2004/079994, JP 2003298111 und JP 2000036616 A beschreiben jeweils ein Halbleiterbauteil und/oder ein Verfahren zur Herstellung eines Halbleiterbauteils, das jeweils einen Kontakt auf einem Halbleiterkörper aufweist.
Temperaturänderungen, wie sie beispielsweise beim Verbinden des Kontaktes mit einem Bonddraht oder im Betrieb des Halbleiterbauelements auftreten, können aufgrund der oftmals unterschiedlichen thermischen Ausdehnungskoeffizienten der Materialien des Kontakts und der Schutzschicht Absplitterungen der Schutzschicht vom Kontakt und/oder dem Halbleiterkörper verursachen. Derartige Absplitterungen können sich effizienzmindernd auf die Funktion des Halbleiterbauelements auswirken.
Eine Absplitterung der Schutzschicht kann auch durch mechanische Belastungen bedingt sein. Beispielsweise kann die Schutzschicht beim Anordnen eines Bonddrahtes auf dem Kontakt vom Kontakt und/oder dem Halbleiterkörper absplittern oder es kann sich ein Hohlraum zwischen Schutzschicht und Halbleiterkörper bilden. Die Schutzschicht ist auf der dem Halbleiterkörper gegenüberliegenden Seite des Kontakts und an den Flanken des Kontakts besonders empfindlich gegenüber mechanischen Belastungen.

Aufgrund des häufig hohen Brechungsindexunterschieds zwischen Luft und dem Material des Halbleiterkörpers kann die Effizienz des Halbleiterbauelements - insbesondere bei der Strahlungsein- bzw. Strahlungsauskopplung - durch Absplitterungen der Schutzschicht verringert werden.

Zur Herstellung des Kontakts wird beispielsweise zuerst der Halbleiterkörper vollflächig mit dem Kontaktmaterial bedeckt. Nachfolgend wird dieses Kontaktmaterial mit einer herkömmlichen Maskentechnik in Form des Kontakts strukturiert. Die Schutzschicht wird hierauf auf den Kontakt und den Halbleiterkörper aufgebracht und in einer nachfolgenden zweiten Maskenebene wird mittels einer weiteren herkömmlichen Maskentechnik die Schutzschicht in Teilbereichen über dem Kontakt geöffnet, um die Anschließbarkeit des Kontakts mit einem Bonddraht zu ermöglichen.

Eine Aufgabe der Erfindung ist es, ein vereinfachtes Verfahren zur Aufbringung eines Kontakts auf einen Halbleiterkörper anzugeben.

Diese Aufgabe wird durch ein Verfahren zur strukturierten Aufbringungen eines Kontakts auf einen Halbleiterkörper mit den Merkmalen des Patentanspruchs 1 gelöst.

Ein strahlungsemittierendes und/oder -empfangendes Halbleiterbauelement umfasst einen Halbleiterkörper, der eine zur Strahlungserzeugung oder zum Strahlungsempfang vorgesehene aktive Zone, eine laterale Haupterstreckungsrichtung und eine Hauptfläche aufweist sowie eine seitens der Hauptfläche angeordnete Schutzschicht und einen seitens der Hauptfläche angeordneten Kontakt, wobei die Schutzschicht von dem Kontakt in lateraler Richtung beabstandet ist.

Durch die beabstandete Anordnung von Schutzschicht und Kontakt wird die Gefahr von thermisch bedingtem Ablösen der Schutzschicht vom Kontakt verringert und die Effizienz des Halbleiterbauelements erhöht.

Bevorzugt ist der Abstand der Schutzschicht vom Kontakt in lateraler Richtung so groß gegenüber dem thermischen Ausdehnungskoeffizienten des Kontakts, dass im Betrieb beziehungsweise beim Verbinden des Kontakts mit einem Bonddraht eine durch die thermische Ausdehnung des Kontakts bedingte Berührung mit der Schutzschicht vermieden wird.

Besonders bevorzugt ist der Kontakt insgesamt von der Schutzschicht beabstandet, so dass sich der Kontakt und die Schutzschicht nicht berühren. Zweckmäßigerweise ist hierzu ein Freiraum zwischen Kontakt und Schutzschicht gebildet.

Weiterhin ist der Abstand zwischen Schutzschicht und Kontakt bevorzugt möglichst klein gehalten, damit die Gefahr einer Schädigung des Halbleiterbauelements aufgrund einer fehlenden Schutzschicht im Bereich zwischen dem Kontakt und der Schutzschicht nicht unnötig erhöht wird. Ein Abstand von weniger als 45 µm, bevorzugt weniger als 25 µm, besonders bevorzugt weniger als 10 µm, und größer oder gleich 0,5 µm, bevorzugt 1 µm, besonders bevorzugt 5 µm, kann als ausreichend angesehen werden.

Insbesondere ist der Abstand zwischen Kontakt und Schutzschicht vorzugsweise kleiner als die Hälfte einer lateralen Ausdehnung einer Kontaktfläche des Kontakts mit einem Bonddraht, die beim Verbinden des Kontaktes mit einem Bonddraht ausgebildet wird. Typische Größen für die Ausdehnung der Kontaktfläche sind beispielsweise 90 µm bis 50 µm. Die Gefahr von mechanisch bedingten Abplatzern der Schutzschicht vom Halbleiterkörper kann dadurch weitergehend verringert werden.

Eine Dicke der Schutzschicht ist zumindest seitens der Hauptfläche kleiner als eine Dicke des Kontakts. Eine Überhöhung der Schutzschicht über die dem Halbleiterkörper gegenüberliegende Seite des Kontakts kann somit vermieden werden. In der Folge wird die Gefahr von Absplitterungen, insbesondere mechanisch bedingten Absplitterungen, der Schutzschicht vom Halbleiterkörper, etwa beim Verbinden des Kontakts mit einem Bonddraht, weitergehend verringert.

In einer bevorzugten Ausgestaltung verläuft die Schutzschicht seitens der Hauptfläche des Halbleiterkörpers im wesentlichen eben, wodurch die Gefahr von Absplitterungen weitergehend erniedrigt wird.
Der Halbleiterkörper kann beispielsweise entsprechend einer Lumineszenzdiode oder einer Photodiode ausgebildet sein. Gemäß einer bevorzugten Ausgestaltung der Erfindung enthält der Halbleiterkörper, insbesondere die aktive Zone, zumindest ein III-V-Halbleitermaterial, etwa ein Material aus den Materialsystemen, InₓGa_{y}Al_{1-x-y}P, InₓGa_{y}Al_{1-x-y}N oder InₓGa_{y}Al_{1-x-y} As, jeweils mit 0≤x≤1, 0≤y≤1 und x+y≤1. Hierbei ist InₓGa_{y}Al_{1-x-y}P beispielsweise für Strahlung vom infraroten bis zum gelben Spektralbereich und InₓGa_{y}Al_{1-x-y}N für Strahlung vom grünen bis in den ultravioletten Spektralbereich besonders geeignet. III-V-Halbleitermaterialien, insbesondere die oben genannten, können sich durch vorteilhaft hohe interne Quanteneffizienz auszeichnen.
In einem erfindungsgemäßen Verfahren zur strukturierten Aufbringung eines Kontakts auf einen Halbleiterkörper, der eine zur Strahlungserzeugung oder zum Strahlungsempfang vorgesehene aktive Zone, eine laterale Haupterstreckungsrichtung und eine Hauptfläche aufweist, wird zunächst der Halbleiterkörper bereitgestellt.
Nach dem Bereitstellen des Halbleiterkörpers wird seitens der Hauptfläche eine Schutzschicht vollflächig auf den Halbleiterkörper aufgebracht. Diese Schutzschicht schützt den Halbleiterkörper vorteilhaft vor schädlichen äußeren Einflüssen.
Bevorzugt ist die Schutzschicht bei der Erfindung strahlungsdurchlässig und/oder elektrisch isolierend ausgebildet. Hierdurch kann ein Kurzschluss der aktiven Zone über das Material der Schutzschicht vermieden werden. Insbesondere gilt dies, falls die Schutzschicht den Halbleiterkörper wenigstens teilweise umformt und/oder an diesen im Bereich der aktiven Zone angrenzt.
In einer bevorzugten Ausgestaltung der Erfindung enthält die Schutzschicht ein Siliziumnitrid, ein Siliziumoxid oder ein Siliziumoxinitrid.
Das Aufbringen der Schutzschicht kann beispielsweise mittels eines Plasmaprozesses erfolgen.
Hierauf wird die Schutzschicht seitens der Hauptfläche des Halbleiterkörpers in einem Kontaktbereich entfernt, woraufhin mindestens ein Kontaktmaterial für den Kontakt im Kontaktbereich angeordnet wird.

Dadurch, dass die Schutzschicht vor dem Kontaktmaterial bzw. dem Kontakt aufgebracht wird, ist die Gefahr einer Schädigung des Halbleiterkörpers oder auf der dem Halbleiterkörper zugewandten Seite der Schutzschicht angeordneten Strukturen durch das Aufbringen des Kontaktmaterials und Strukturierungsverfahren zum Aufbringen des Kontaktmaterials verringert. Ferner ist der Schutz des Halbleiterkörpers während der weiteren Prozessierung vorteilhaft erhöht.
Vor der Entfernung der Schutzschicht im Kontaktbereich wird auf der Schutzschicht gemäß der Erfindung eine Maske angeordnet, deren Struktur die laterale Abmessung des Kontaktbereichs bestimmt. Die Maske kann auf der Schutzschicht strukturiert angeordnet oder nach dem Anordnen entsprechend strukturiert werden. Bevorzugt enthält die Maske ein fotostrukturierbares Material, wie einen Fotolack, der entsprechend der Maskenstruktur belichtet und entwickelt wird.

Gemäß der Erfindung bestimmt die Maske über ihre Struktur die laterale Abmessung des Kontakts, der bevorzugt durch Aufdampfen mindestens eines Kontaktmaterials seitens der Hauptfläche des Halbleiterkörpers im Kontaktbereich angeordnet wird.
Zur Entfernung der Schutzschicht im Kontaktbereich kann so mit Vorteil die gleiche Maske verwendet werden, wie zur Ausbildung des Kontakts. Eine aufwendige zusätzliche Maskenebene kann vermieden werden. Gemäß der Erfindung wird das Kontaktmaterial im Kontaktbereich derart angeordnet, dass ein Kontakt ausgebildet wird, der verglichen mit der Schutzschicht eine größere Dicke aufweist. Eine Überhöhung der Schutzschicht über die dem Halbleiterkörper abgewandte Seite des Kontakts kann so vermieden werden.

Ein Überlapp des Kontakts und der Schutzschicht auf der dem Halbleiterkörper abgewandten Seite des Kontakts wird jedoch durch eine Aufbringung des Kontaktmaterials nach der Schutzschicht mit Vorteil vermieden.
Weiterhin ist die Schutzschicht vorzugsweise im Wesentlichen eben auf der Hauptfläche des Halbleiterkörpers angeordnet und erstreckt sich insbesondere nicht in vertikaler Richtung am Kontakt entlang in Richtung der dem Halbleiterkörper gegenüberliegenden Seite des Kontakts.

Gemäß der Erfindung ist der gemäß des erfindungsgemäßen Verfahrens aufgebrachte Kontakt in lateraler Richtung von der Schutzschicht beabstandet. Hierzu ist ein Kontaktbereich vorgesehen, der eine verglichen mit der Fläche des Kontakts seitens der Hauptfläche des Halbleiterkörpers vergrößerte laterale Fläche einnimmt.

Gemäß der Erfindung wird die Schutzschicht im Kontaktbereich derart entfernt, dass die Schutzschicht auch in einem unter der Maskenstruktur liegenden beziehungsweise von dieser abgeschattetem Bereich entfernt wird. Hierzu wird ein nasschemisches Ätzverfahren verwendet, das eine Unterätzung der Maskenstruktur bewirken und somit die Ausbildung eines Kontaktbereichs mit einer Fläche, die größer als die Fläche des Kontakts seitens des Halbleiterkörpers ist, erleichtert.

Gemäß der Erfindung ist auf dem Halbleiterkörper eine Stromaufweitungsschicht angeordnet. Diese Stromaufweitungsschicht ist zwischen der Schutzschicht und dem Halbleiterkörper angeordnet und/oder elektrisch leitend mit dem Kontakt verbunden.
Eine derartige Stromaufweitungsschicht kann die Stromeinprägung in den Halbleiterkörper, insbesondere von der Seite des Kontakts her, vorteilhaft verbessern. Besonders bevorzugt weist die Stromaufweitungsschicht eine Querleitfähigkeit - Leitfähigkeit in lateraler Richtung - auf, die größer ist als die des im Halbleiterkörper seitens des Kontakts angeordneten Halbleitermaterials. Mit Vorteil kann so die bestromte Fläche der aktiven Zone im Halbleiterkörper und somit die Effizienz des Halbleiterbauelements erhöht werden. Geeignete Materialien mit hoher Querleitfähigkeit sind beispielsweise Metalle oder TCO-Materialien (TCO: Transparent Conducting Oxide), wie ZnO, SnO, TiO oder ITO, wobei sich TCO-Materialien neben hoher Querleitfähigkeit auch durch hohe Strahlungsdurchlässigkeit über einen weiten Wellenlängenbereich auszeichnen können. TCO-haltige Stromaufweitungsschichten können beispielsweise auf den Halbleiterkörper gesputtert, metallhaltige Stromaufweitungsschichten auf den Halbleiterkörper gedampft oder gesputtert werden.
Gemäß einer vorteilhaften Weiterbildung der Erfindung umfasst die Stromaufweitungsschicht eine semitransparente, vorzugsweise metallhaltige, Schicht. Semitransparent bedeutet hierbei, dass auf den Halbleiterkörper einfallende oder im Halbleiterkörper erzeugte Strahlung nur zu einem vergleichsweise geringen, tolerablen Anteil in der Stromaufweitungsschicht absorbiert wird. Die Stromaufweitungsschicht ist hierzu zweckmäßigerweise vergleichsweise dünn, etwa mit Dicken zwischen einschließlich 50 nm und einschließlich 1 nm, vorzugsweise zwischen einschließlich 25 nm bis einschließlich 2 nm ausgeführt. Als besonders vorteilhaft haben sich Dicken von 15 nm oder weniger erwiesen. Beispielsweise enthält die Stromaufweitungsschicht Pt, Pd, Ni, Au oder eine Legierung mit mindestens einem dieser Materialien, wie NiAu.
Die Schutzschicht verringert mit Vorteil die Gefahr einer Schädigung der Stromaufweitungsschicht, insbesondere einer vergleichsweise kratzempfindlichen semitransparenten, Stromaufweitungsschicht.
Die Schutzschicht ist bevorzugt als Kratzschutzschicht ausgebildet, die gegenüber mechanische Belastungen, wie Kratzern, stabiler ist als die Stromaufweitungsschicht. Die Gefahr von großflächigen Kratzern, die ganze Segmente der Stromaufweitungsschicht abtrennen können wird so verringert.

Die Stromaufweitungsschicht wird vor der Schutzschicht auf den Halbleiterkörper aufgebracht und wird damit durch die Schutzschicht schon während des Aufbringens des Kontakts geschützt.
Insbesondere wird so weitgehend verhindert, dass das beim Aufbringen des Kontakts verwendete Maskenmaterial direkt auf die Stromaufweitungsschicht gelangt. Die Gefahr von Rückständen des Maskenmaterials nach dem Entfernen der Maskenstruktur auf der Stromaufweitungsschicht wird in der Folge verringert. Maskenmaterialrückstände im allgemeinen können sich effizienzmindern auf Halbleiterbauelemente auswirken, indem sie beispielsweise Kratzer verursachen, Strahlung absorbieren oder aufgrund ihrer oftmals nichtleitenden Eigenschaften, insbesondere bei einer Anordnung zwischen dem Kontakt und der Stromaufweitungsschicht, die Effizienz der Stromeinbringung in die aktive Zone vermindern können.

In herkömmlichen Halbleiterbauelementen wird die Schädigung der Stromaufweitungsschicht durch von Maskenmaterialrückständen verursachte Kratzern häufig in Kauf genommen oder die Rückstände werden durch aufwendige Reinigungsverfahren beseitigt. Die hierzu geeigneten Reinigungsverfahren können sich aber wiederum schädlich auf die Stromaufweitungsschicht, insbesondere eine semitransparente, auswirken. Weiterhin kann sich ein derartiges Reinigungsverfahren schädlich auf den Halbleiterkörper, insbesondere auf GaN-basierende und/oder p-leitende Halbleitermaterialien, auswirken. In der Folge kann es beispielsweise zu einer nachteiligen Erhöhung der Flussspannung des Halbleiterbauelements kommen. Bei der Erfindung hingegen ist die Stromaufweitungsschicht weitestgehend durch die Schutzschicht vor den Rückständen geschützt. Eine Reinigung der Stromaufweitungsschicht kann so vermieden werden

Beim Entfernen der Maske, beispielsweise über Ätzen, kann die Schutzschicht außerdem als Barrierenschicht dienen, die die Gefahr einer Schädigung der Stromaufweitungsschicht durch die Prozesse zum Entfernen der Maske verringert.

In einer bevorzugten Ausgestaltung der Erfindung ist der Kontakt und/oder die vom Kontakt beabstandete Schutzschicht auf einer p-leitenden Seite des Halbleiterkörpers angeordnet. Besonders bevorzugt ist auch die Stromaufweitungsschicht auf der p-leitenden Seite des Halbleiterkörpers angeordnet.

Weitere Merkmale, Vorteile und Zweckmäßigkeiten der Erfindung ergeben sich aus der nachfolgenden Beschreibung der Ausführungsbeispiele in Verbindung mit den Figuren.

Es zeigen:
- Figur 1: ein Ausführungsbeispiel eines erfindungsgemäßen Verfahrens anhand von in den Figuren 1A bis 1G schematisch in Schnittansichten dargestellten Zwischenschritten,
- Figur 2: ein Beispiel eines strahlungsemittierenden und/oder -empfangenden Halbleiterbauelements anhand einer schematischen Schnittansicht.
Gleichartige und gleich wirkende Elemente sind in den Figuren mit den gleichen Bezugszeichen versehen.

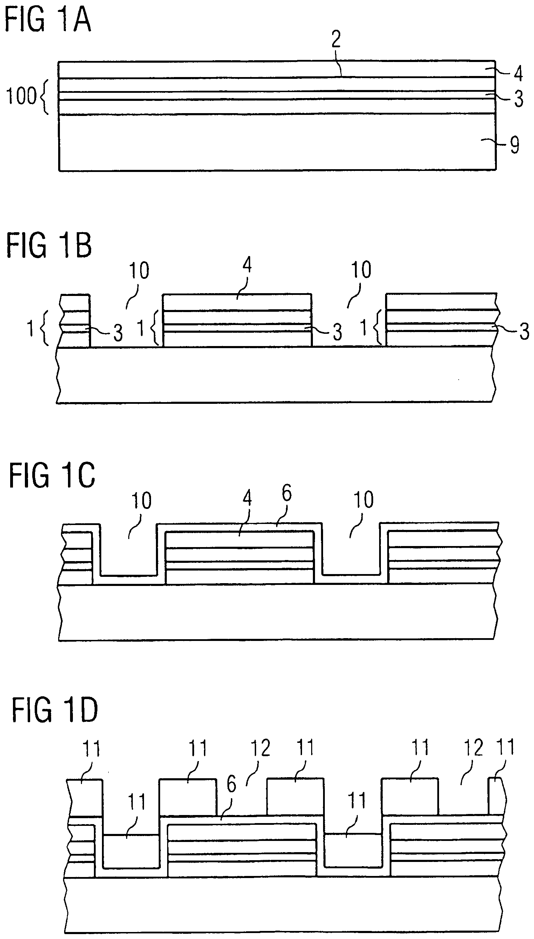

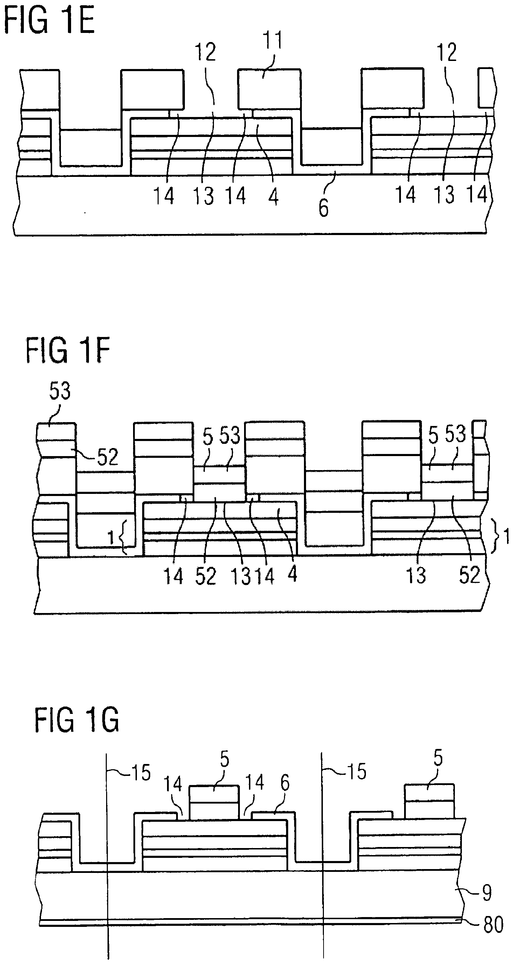

In Figur 1 ist ein Ausführungsbeispiel eines erfindungsgemäßen Verfahrens zur strukturierten Aufbringung eines Kontakts auf einen Halbleiterkörper anhand von in den Figur 1A bis 1G schematisch dargestellten Zwischenschritten gezeigt. Insbesondere ist in Figur 1 ein Verfahren zur strukturierten Aufbringung eines Kontakts auf eine Mehrzahl von Halbleiterkörpern gezeigt, das im Waferverbund durchführbar ist.
Unter einem Waferverbund ist bei der Erfindung eine auf einer Trägerschicht angeordnete Halbleiterschichtenfolge, die zur Ausbildung einer Mehrzahl von Halbleiterkörpern vorgesehen ist, zu verstehen. Die Trägerschicht ist vorzugsweise freitragend und umfasst das Aufwachssubstrat, auf dem die Halbleiterschichtenfolge, beispielsweise epitaktisch, gewachsen wurde.

In Figur 1A ist eine Halbleiterschichtenfolge 100 mit einer Hauptfläche 2 und einer aktiven Zone 3 auf einer Trägerschicht 9 angeordnet. Die Trägerschicht 9 umfasst das Aufwachssubstrat der Halbleiterschichtenfolge, beispielsweise aus SiC, Saphir oder GaN im Falle von auf dem Materialsystem InₓGa_{y}Al_{1-x-y}N basierenden Halbleiterschichtenfolgen.

Die Stromaufweitungsschicht 4, auf der Hauptfläche 2 der Halbleiterschichtenfolge angeordnet, ist vorzugsweise nach der Herstellung der Halbleiterschichtenfolge, etwa durch Aufdampfen im Waferverbund aufgebracht, weist eine Dicke von ungefähr 5 nm auf und/oder besteht aus Pt. Vorzugsweise ist die Halbleiterschichtenfolge seitens der Stromaufweitungsschicht p-leitend. Pt zeichnet sich durch vorteilhafte Kontakteigenschaften, insbesondere zu GaNbasierenden und/oder p-leitenden Halbleitermaterialien aus.
Die aktive Zone kann beispielsweise eine Ein- oder Mehrfach-Quantentopf oder -heterostruktur, etwa eine Doppelheterostruktur, umfassen.
Hierauf wird von der der Trägerschicht gegenüberliegenden Seite die Halbleiterschichtenfolge, beispielsweise über Maskierungsprozesse - z.B. mittels einer Fotolackmaske - in Kombination mit Ätzprozessen, derart strukturiert, dass eine Mehrzahl von durch Zwischenräume 10 räumlich voneinander getrennten, auf der Trägerschicht angeordneten, vorzugsweise gleichartigen, Halbleiterkörpern 1 entsteht.
Um die Gefahr einer Schädigung der (kratz)empfindlichen Stromaufweitungsschicht 4 während des Maskierungsprozesses zu verringern, kann hierbei zwischen dem Maskenmaterial und der Stromaufweitungsschicht eine Zwischenschicht, beispielsweise Au enthaltend, vorgesehen werden, die nach dem Strukturieren der Halbleiterschichtenfolge zusammen mit der Maskenstruktur auf für die Stromaufweitungsschicht unschädliche Weise wieder entfernt wird. Die aus diesem Strukturierungsprozess hervorgehende Struktur ist in Figur 1B anhand einer Schnittansicht schematisch dargestellt.
Nachfolgend wird seitens der Halbleiterkörper eine strahlungsdurchlässige, elektrisch isolierende Schutzschicht, beispielsweise aus SiON, vollflächig aufgebracht. Die Schutzschicht 6 umformt die Halbleiterkörper allseitig, ist auch im Bereich der Zwischenräume 10 angeordnet und/oder mit der Trägerschicht in Kontakt. Diese Schutzschicht schützt den Halbleiterkörper vor schädlichen äußeren Einflüssen, insbesondere an den seitlichen Flanken, und wirkt auch als Schutzschicht für die Stromaufweitungsschicht 4, während der weiteren Prozessierung der in Figur 1C anhand einer schematischen Schnittansicht dargestellten Struktur. Vorzugsweise zeichnet sich die Schutzschicht durch eine gegenüber angrenzenden Medien, etwa Luft, erhöhte elektrische Durchschlagsfestigkeit aus. Die Gefahr eines Kurzschlusses der aktiven Zone wird so verringert.
Die Schutzschicht kann beispielsweise mittels eines Plasmaprozesses aufgebracht werden.
Hierauf wird auf die Schutzschicht 6 eine Maskenstruktur 11 aufgebracht. Die Maskenstruktur ist bevorzugt so ausgestaltet, dass sie Aussparungen 12 über den zur Ausbildung des Kontakts vorgesehenen Bereichen der Halbleiterkörper 1 aufweist.
Zur Ausbildung der Maskenstruktur kann zuerst ein Maskenmaterial vollflächig auf die in Figur 1C gezeigte Struktur aufgebracht und nachfolgend entsprechend der Maskenstruktur strukturiert werden oder das Maskenmaterial kann bereits strukturiert aufgebracht werden.
Im ersten Fall wird hierzu das Maskenmaterial, z. B. ein Fotolack, schichtartig aufgebracht, entsprechend der Maskenstruktur belichtet und entwickelt. Eventuell zurückbleibende Reste des Maskenmaterials im Bereich des Bodens der Aussparung 12, der hier durch die Schutzschicht 6 gebildet wird, können durch ein geeignetes Verfahren entfernt werden. So kann beispielsweise ein gasgestütztes Verfahren, wie ein sogenannter N₂O-Flash, verwendet werden. Die Halbleiterkörper 1 und/oder die Stromaufweitungsschicht 4 sind hierbei jeweils vor den eventuell schädlichen Auswirkungen dieses Entfernungsverfahrens durch die Schutzschicht 6 geschützt.
In Figur 1D ist die Maskenstruktur 11 mit den Aussparungen 12, die bis zur Schutzschicht 6 hinabreichen, anhand einer Schnittansicht schematisch dargestellt.
Nachfolgend wird die Schutzschicht 6 in Kontaktbereichen 13 entfernt. Dies erfolgt über nasschemisches Ätzen, etwa mit HF. Der Kontaktbereich 13 wird in Schnittansicht breiter ausgebildet als die durch den Boden der Aussparung 12 definierte Struktur was durch Unterätzen der Maskenstruktur in von dieser abgeschatteten bzw. überdeckten Bereichen in lateraler Richtung erfolgt. In Figur 1E ist die daraus hervorgehende Struktur anhand einer Schnittansicht schematisch dargestellt. Die Schutzschicht 6 ist in Kontaktbereichen 13 von den Stromaufweitungsschichten 4 entfernt und die Maskenstruktur 11 ragt in Teilbereichen 14 über den Kontaktbereich 13. Die Aussparung und der Kontaktbereich können beispielsweise eine in Aufsicht im Wesentlichen kreisförmige Gestalt haben. Die lateralen Abmessungen der Kontaktbereiche sind geringer als die der Halbleiterkörper bzw. der Stromaufweitungsschichten 4 und die der Aussparungen 12 wiederum geringer als die der Kontaktbereiche 13.
Auf die in Figur 1E gezeigte Struktur wird nachfolgend, vorzugsweise vollflächig, mindestens ein Kontaktmaterial derart aufgebracht, dass das Kontaktmaterial jeweils im Kontaktbereich leitend mit der Stromaufweitungsschicht 4 und somit der aktiven Zone 3 verbunden ist.
In diesem Ausführungsbeispiel werden zwei verschiedene Kontaktmaterialien in Form von zwei Kontaktschichten 52, 53 nacheinander auf die in Figur 1E gezeigte Struktur aufgebracht. Bevorzugt enthalten beide Kontaktschichten zumindest ein Metall oder Legierungen und/oder werden durch Aufdampfen aufgebracht. Die zuerst aufgebrachte Kontaktschicht 52 zeichnet sich besonders bevorzugt durch gute elektrische Kontakteigenschaften zum Material der Stromaufweitungsschicht aus. Das Material der Kontaktschicht 52 kann z.B. identisch mit dem der Stromaufweitungsschicht 4, etwa Pt, sein. Die nachfolgend aufgebrachte Kontaktschicht 53 zeichnet sich besonders bevorzugt durch gute Eigenschaften hinsichtlich eines später durchgeführten Wire-Bond-Vorgang (leitende Verbindung des Kontakts mit einem Bonddraht) aus und enthält beispielsweise Au. Insgesamt kann so ein vorteilhaft niederohmiger elektrischer Kontakt zum Halbleiterkörper hergestellt werden.
Die erste 52 und die zweite Kontaktschicht 53 sind in den Kontaktbereichen 13 jeweils Teil eines Kontakts 5 für die Halbleiterkörper 1. Dies ist anhand einer schematischen Schnittansicht in Figur 1F dargestellt. Die Maskenstruktur 11 wird bei einem erfindungsgemäßen Verfahren demnach sowohl als Maske für eine bereichsweise Entfernung der Schutzschicht als auch als Maske für die Aufbringung eines Kontakts zum Halbleiterkörper benutzt. Verglichen mit herkömmlichen Verfahren ist die Anzahl der Maskierungsschritte vorteilhaft verringert. Ferner ist das Verfahren vorteilhaft im Waferverbund durchführbar.
Nachfolgend kann die Maskenstruktur mit den darauf befindlichen Kontaktmaterialien von der in Figur 1F gezeigten Struktur, wie bei einem derartigen Lift-Off-Prozess üblich, entfernt werden. Die Schutzschicht 6 wirkt hierbei als die Stromaufweitungsschichten 4 bzw. die Halbleiterkörper 1 schützende Barrierenschicht.
Die hieraus resultierende Struktur ist in Figur 1G anhand einer Schnittansicht schematisch dargestellt. Der Kontakt 5 ist von der Schutzschicht 6 in lateraler Richtung beabstandet, wobei die Beabstandung durch die Teilbereiche 14 bestimmt wird, die beim Entfernen der Schutzschicht im Kontaktbereich 13 ausgebildet wurden.
Entlang der Linien 15 kann der Verbund aus Figur 1G, beispielsweise durch Sägen, Wasserstrahlschneiden, Lasertrennen oder ein anderes geeignetes Verfahren in Halbleiterbauelemente vereinzelt werden.
Vor dem Vereinzeln kann noch eine elektrisch leitende Gegenkontaktschicht 80 auf die den Halbleiterkörpern abgewandte Seite der Trägerschicht 9 aufgebracht werden, sodass die Halbleiterbauelemente über den Kontakt 5 und den aus der Gegenkontaktschicht 80 beim Vereinzeln hervorgehenden Gegenkontakt elektrisch anschließbar sind. Die Trägerschicht 9 ist hierzu mit Vorteil entsprechend, beispielsweise n-leitend dotiert.
Die Gefahr von Abplatzern der Schutzschicht von dem Halbleiterkörper beim Verbinden des Kontakts 5 mit einem Bonddraht wird durch die Beabstandung des Kontakts von der Schutzschicht in lateraler Richtung, wie in Figur 1G dargestellt, reduziert. Auch eine vorzugsweise geringere Dicke der Schutzschicht verglichen mit der Dicke des Kontakts trägt dazu bei, die Gefahr von Abplatzern der Schutzschicht vom Halbleiterkörper zu verringern.

Die elektrische Abtrennung von ganzen Segmenten der Stromaufweitungsschicht 4 vom Kontakt durch großflächige Kratzer ist aufgrund des vergleichsweise geringen Abstandes, etwa im Bereich von 2µm, von Kontakt und Schutzschicht erschwert. Kleinere in den Teilbereichen 14 mit entfernter Schutzschicht entstehende Kratzer können vom in den Halbleiterkörper einzuprägenden Strom umflossen werden und verringern die Effizienz des Halbleiterbauelements mit Vorteil nicht maßgeblich.

Da die Stromaufweitungsschicht während des Aufbringens der Maskenstruktur für den Kontakt durch die Schutzschicht vor Maskenmaterialrückständen geschützt war und somit eine verglichen mit herkömmlichen Bauelementen unbehandelte bzw. unbeschädigte Oberfläche aufweist, kann auf eine zusätzliche, zur Stromaufweitungsschicht haftvermittelnde Kontaktschicht, etwa aus Ti, verzichtet werden.

Derartige haftvermittelnde Kontaktschichten können auch bei während der Prozessierung vergleichsweise ungeschützten Oberflächen eine ausreichende, mechanische oder elektrisch leitende Verbindung des Kontakts zur Stromaufweitungsschicht herstellen, sind jedoch häufig derart feuchtempfindlich, dass sie aufwendig geschützt werden müssen, um die Kontakteigenschaften über die Betriebsdauer des Halbleiterbauelements nicht unnötig zu verschlechtern. In herkömmlichen Halbleiterbauelementen wird hierzu häufig die Schutzschicht bis auf die dem Halbleiterkörper abgewandte Seite des Kontakts gezogen, was jedoch die eingangs erwähnten Nachteile hinsichtlich Absplitterung aufweist.

Bei der Erfindung können weiterhin aufwendige und gefahrenbehaftete Reinigungsverfahren der Stromaufweitungsschicht, insbesondere von Maskenmaterialrückständen vermieden werden.
Die Schutzschicht 6 wirkt demnach bei dem erfindungsgemäßen Verfahren bzw. dem unter Benutzung des Verfahrens hergestellten Halbleiterbauelementen als Passivierung der Flanken des Halbleiterkörpers, als Kratzschutzschicht für die Stromaufweitungsschicht beziehungsweise den Halbleiterkörper und als Barrierenschicht bei der Herstellung, die die Gefahr einer Beschädigung des Halbleiterkörpers bzw. der Stromaufweitungsschicht, insbesondere während der Entfernung der Maskenstruktur 11, weitestgehend verringert.

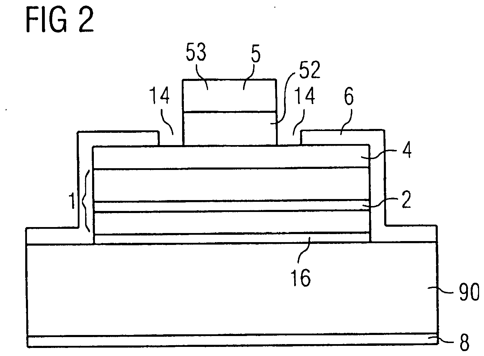

In Figur 2 ist ein Beispiel eines strahlungsemittierenden und/oder -empfangenden Halbleiterbauelements anhand einer Schnittansicht schematisch dargestellt. Die Struktur des Halbleiterbauelements entspricht im Wesentlichen der beim Vereinzeln aus Figur 1G hervorgehenden Struktur.
Im Gegensatz zu den in Figur 1G skizzierten Strukturen ist in Figur 2 zwischen dem beim Vereinzeln aus der Trägerschicht 9 hervorgehenden Träger 90 und dem Halbleiterkörper 1 eine Spiegelschicht 16 angeordnet, die die Effizienz eines Halbleiterbauelements erhöhen kann. Bevorzugt enthält die Spiegelschicht ein Metall, etwa Au, Al, Ag, Pt oder Legierungen mit mindestens einem dieser Materialien. Au beispielsweise zeichnet sich durch eine vorteilhaft hohe Reflektivität im roten Spektralbereich aus, während Al und Ag auch im ultravioletten und blauen Spektralbereich eine hohe Reflektivität aufweisen können. Die Spiegelschicht wird bevorzugt im Waferverbund auf die Halbleiterschichtenfolge, die auf einer ersten Trägerschicht angeordnet ist, auf die der ersten Trägerschicht abgewandten Seite der Halbleiterschichtenfolge aufgebracht. Bevorzugt umfasst die erste Trägerschicht das Aufwachssubstrat der Halbleiterschichtenfolge. Das Aufbringen der Spiegelschicht kann etwa durch Sputtern oder Aufdampfen erfolgen. Nach dem Aufbringen der Spiegelschicht wird der Verbund aus erster Trägerschicht und Halbleiterschichtenfolge seitens der Spiegelschicht auf einer zweiten Trägerschicht angeordnet. Diese Anordnung kann beispielsweise mittels einer Lotverbindung, einer Klebeverbindung oder eines Waferbonding-Verfahren geschehen. Die erste Trägerschicht der Halbleiterschichtenfolge kann daraufhin von der Halbleiterschichtenfolge abgelöst werden. Zum Ablösen eignen sich beispielsweise lasergestützte Verfahren, wie etwa ein Laser-Ablationsverfahren, mechanische Methoden, wie Abschleifen, oder Ätzverfahren.
Zum Ausbilden des Kontaktes kann entsprechend dem in Figur 1 gezeigten Verfahren vorgegangen werden. Zwischen der - in diesem Falle zweiten Trägerschicht 9 - und der Halbleiterschichtenfolge 100 in Figur 1A ist nun jedoch eine Spiegelschicht 16 angeordnet. Das Halbleiterbauelement ist über den Kontakt 5 und den Gegenkontakt 8, der beim Vereinzeln aus der Gegenkontaktschicht 80 hervorgeht anschließbar.
Unter Ablösen des Aufwachssubstrats der Halbleiterschichtenfolge hergestellte optoelektronische Halbleiterchips werden oftmals auch als Dünnfilm-Chips bezeichnet. Die zweite Trägerschicht kann verglichen mit dem Aufwachssubstrat vergleichsweise frei gewählt werden. So kann die zweite Trägerschicht hinsichtlich mancher Eigenschaften, wie etwa Leitfähigkeit oder Stabilität, für Halbleiterbauelemente besser geeignet sein, als verfügbare Aufwachssubstrate, die zur Herstellung hochwertiger Halbleiterschichtenfolgen vergleichsweise engen Restriktionen unterliegen.
Bevorzugt zeichnet sich die zweite Trägerschicht jedoch durch einen an die Halbleiterschichtenfolge angepassten thermische Ausdehnungskoeffizienten aus. Beispielsweise kann die zweite Trägerschicht ein Halbleitermaterial, wie GaN, SiC oder ein andersartiges Material, beispielsweise Saphir enthalten. Auch metallische zweite Trägerschichten sind möglich.
Derartig hergestellte, zur Strahlungserzeugung vorgesehene Halbleiterchips können sich, insbesondere mit einer metallhaltigen Spiegelschicht, durch eine im wesentlichen einem Lambertschen-Strahler entsprechende zumindest annähernd kosinusförmige Abstrahlcharakteristik auszeichnen.

## Patentansprüche

1. Verfahren zur strukturierten Aufbringung eines Kontakts (5) auf einen Halbleiterkörper (1), der eine zur Strahlungserzeugung oder zum Strahlungsempfang vorgesehene aktive Zone (3), eine laterale Haupterstreckungsrichtung und eine Hauptfläche aufweist,
mit den Schritten,
a) Aufwachsen einer Halbleiterschichtenfolge (100) auf einem Aufwachssubstrat,
b) Aufbringen einer Stromaufweitungsschicht (4) auf eine Hauptfläche der Halbleiterschichtenfolge (100) und Erzeugung von Zwischenräumen (10) durch die Stromaufweitungsschicht (4) und die Halbleiterschichtenfolge (100), wobei aus der Halbleiterschichtenfolge (100) die räumlich voneinander getrennten Halbleiterkörper (1) entstehen,
c) Aufbringen einer Schutzschicht (6) auf die Stromaufweitungsschicht (4) und in den Zwischenräumen (10), sodass die Stromaufweitungsschicht (4) zwischen der Schutzschicht (6) und dem Halbleiterkörper (1) angeordnet wird und die Schutzschicht (6) den Halbleiterkörper (1) allseitig umformt,
d) Anordnen einer Maske (11) auf der Schutzschicht (6),
e) Entfernen der Schutzschicht (6) auf der Hauptfläche des Halbleiterkörpers (1) in einem Kontaktbereich (13),
f) Anordnen mindestens eines Kontaktmaterials (52,53) für den Kontakt (5) im Kontaktbereich (13), und
g) Entfernen der Maske (11),
wobei
- die Schutzschicht (6) eine Höhe aufweist, die geringer ist als die Höhe des Kontakts (5),
- die Schutzschicht (6) in Schritt e) mittels naßchemischem Ätzen entfernt und die Maske (11) unterätzt wird, sodass die Maske (11) in Teilbereichen (14) über den Kontaktbereich (13) ragt,
- der Kontakt (5) nach dem Entfernen der Maske (11) von der Schutzschicht (6) in lateraler Richtung beabstandet ist, und
- die Struktur der Maske (11) die laterale Abmessung des Kontaktbereichs (13) und die laterale Abmessung des Kontakts (5) bestimmt.

2. Verfahren nach dem vorhergehenden Anspruch,
**dadurch gekennzeichnet, dass**
die Dicke der Stromaufweitungsschicht (4) kleiner oder gleich 50 nm, vorzugsweise 25 nm, ist.

3. Verfahren nach einem der vorhergehenden Ansprüche,
**dadurch gekennzeichnet, dass**
die Dicke der Stromaufweitungsschicht größer oder gleich 1 nm, vorzugsweise 2 nm, ist.

4. Verfahren nach einem der vorhergehenden Ansprüche,
**dadurch gekennzeichnet, dass**
die Schutzschicht als Schutzschicht gegen mechanische Beschädigungen der Stromaufweitungsschicht ausgebildet ist.

5. Verfahren nach einem der vorhergehenden Ansprüche,
**dadurch gekennzeichnet, dass**
der Halbleiterkörper (1), insbesondere die aktive Zone (3), zumindest ein III-V-Halbleitermaterial, vorzugsweise ein III-V-Halbleitermaterial aus den Halbleitermaterialsystemen InxGayAl1-x-yP, InxGayAl1-x-yN oder InxGayAl1-x-y As, jeweils mit 0≤x≤1, 0≤y≤1 und x+y≤1, enthält.

6. Verfahren nach einem der vorhergehenden Ansprüche,
**dadurch gekennzeichnet, dass**
die Stromaufweitungsschicht eine semitransparente metallhaltige Schicht umfasst.

## Claims

1. A method for structured application of a contact (5) to a semiconductor body (1) which comprises an active zone (3) provided for generating radiation or for receiving radiation, a lateral main extension direction and a main surface,
the method comprises the steps of:
a) growing a semiconductor layer sequence (100) on a growth substrate,
b) applying a current spreading layer (4) to a main surface of the semiconductor layer sequence (100) and generating interspaces (10) through the current spreading layer (4) and the semiconductor layer sequence (100), wherein the semiconductor bodies (1) which are spatially separated from one another are formed from the semiconductor layer sequence (100),
c) applying a protective layer to the current spreading layer and into the interspaces so that the current spreading layer (4) is arranged between the protective layer (6) and the semiconductor body (1), and the protective layer (6) is formed onto the semiconductor body (1) on all sides,
d) arranging a mask (11) on the protective layer (6),
e) removing the protective layer (6) on the main surface of the semiconductor body from a contact region (13),
f) arranging at least one contact material (52, 53) for the contact (5) in the contact region (13), and
g) removing the mask (11),
wherein
- the protective layer (6) has a height which is less than the height of the contact (5),
- the protective layer (6) is removed in step e) by means of wet-chemical etching and the mask (11) is undercut so that the mask (11) projects beyond the contact region (13) in partial regions (14),
- the contact (5) is spaced apart from the protective layer (6) in the lateral direction after the removal of the mask (11), and
- the structure of the mask (11) determines the lateral dimension of the contact region (13) and the lateral dimension of the contact (5).

2. The method according to the preceding claim,
**characterized in that**
the thickness of the current spreading layer (4) is less than or equal to 50 nm, preferably 25 nm.

3. The method according to one of the preceding claims,
**characterized in that**
the thickness of the current spreading layer is greater than or equal to 1 nm, preferably 2 nm.

4. The method according to one of the preceding claims,
**characterized in that**
the protective layer is designed as a protective layer against mechanical damage to the current spreading layer.

5. The method according to one of the preceding claims,
**characterized in that**
the semiconductor body (1), in particular the active zone (3), comprises at least one III-V semiconductor material, preferably a III-V semiconductor material from the semiconductor material systems InxGayAl1-x-yP, InxGayAl1-x-yN or InxGayAll-x-y As, in each case with 0 ≤ x ≤ 1, 0 ≤ y ≤ 1 and x + y ≤ 1.

6. The method according to one of the preceding claims,
**characterized in that**
the current spreading layer comprises a semi-transparent metal-containing layer.

## Revendications

1. Procédé d'application structurée d'un contact (5) sur un corps semi-conducteur (1), qui présente une zone active (3) prévue pour la génération d'un rayonnement ou la réception d'un rayonnement, une direction d'extension principale latérale et une surface principale, comprenant les étapes suivantes :
a) développement d'une succession de couches semi-conductrices (100) sur un substrat de croissance,
b) application d'une couche d'élargissement de courant (4) sur une surface principale de la succession de couches semi-conductrices (100) et génération d'espaces interstitiels (10) par la couche d'élargissement de courant (4) et la succession de couches semi-conductrices (100), dans lequel les corps semi-conducteurs (1) spatialement séparés les uns des autres voient le jour au départ de la succession de couches semi-conductrices (100),
c) application d'une couche de protection (6) sur la couche d'élargissement de courant (4) et dans les espaces interstitiels (10), de sorte que la couche d'élargissement de courant (4) soit disposée entre la couche de protection (6) et le corps semi-conducteur (1) et que la couche de protection (6) enveloppe le corps semi-conducteur (1) en tous sens,
d) disposition d'un masque (11) sur la couche de protection (6),
e) retrait de la couche de protection (6) sur la surface principale du corps semi-conducteur (1) dans une zone de contact (13),
f) disposition d'au moins un matériau de contact (52, 53) pour le contact (5) dans la zone de contact (13), et
g) retrait du masque (11), dans lequel
- la couche de protection (6) présente une hauteur inférieure à la hauteur du contact (5),
- la couche de protection (6) est, à l'étape e) retirée par gravure chimique humide et le masque (11) sous-gravé, de sorte que le masque (11) dépasse de la zone de contact (13) dans des zones partielles (14),
- le contact (5) est distant latéralement de la couche de protection (6) après le retrait du masque (11), et
- la structure du masque (11) détermine la dimension latérale de la zone de contact (13) et la dimension latérale du contact (5).

2. Procédé selon la revendication précédente, **caractérisé en ce que** l'épaisseur de la couche d'élargissement de courant (4) est inférieure ou égale à 50 nm, de préférence 25 nm.

3. Procédé selon l'une des revendications précédentes, **caractérisé en ce que** l'épaisseur de la couche d'élargissement de courant est supérieure ou égale à 1 nm, de préférence 2 nm.

4. Procédé selon l'une des revendications précédentes, **caractérisé en ce que** la couche de protection est exécutée sous la forme d'une couche de protection contre les détériorations mécaniques de la couche d'élargissement de courant.

5. Procédé selon l'une des revendications précédentes, **caractérisé en ce que** le corps semi-conducteur (1), en particulier la zone active (3), contient au moins un matériau semi-conducteur III-V, de préférence un matériau semi-conducteur III-V issu des systèmes de matériaux semi-conducteurs InxGayAl1-x-yP, InxGay Al1-x-yN ou InxGayAl1-x-y As, respectivement avec 0≤x≤1, 0≤y≤1 et x+y≤1.

6. Procédé selon l'une des revendications précédentes, **caractérisé en ce que** la couche d'élargissement de courant englobe une couche semi-transparente contenant un métal.
